# EUROPÄISCHE PATENTSCHRIFT

(11) **EP 3 964 846 B1**
(45) Veröffentlichungstag und Bekanntmachung des Hinweises auf die Patenterteilung: **12.02.2025**
(21) Anmeldenummer: 21193021.9
(22) Anmeldetag: 25.08.2021
(51) Int. Cl.: G01R 27/02, G01R 27/18, G01R 31/00, G01R 31/12

(54) **ANORDNUNG MIT EINEM SPANNUNGSMODUL**
ARRANGEMENT WITH A TENSION MODULE
AGENCEMENT DOTÉ D'UN MODULE DE TENSION

(30) Priorität: 02.09.2020 DE 102020211048
(43) Veröffentlichungstag der Anmeldung: 09.03.2022
(73) Patentinhaber: Siemens Mobility GmbH, 81739 München (DE)
(72) Erfinder: Glinka, Martin, 91054 Buckenhof (DE); Jaumann, Tony, 90419 Nürnberg (DE); Quast, Fabian, 91058 Erlangen (DE)
(74) Vertreter: Siemens Patent Attorneys

(56) Entgegenhaltungen:
- EP-A1- 3 620 800
- DE-A1- 102014 018 622
- DE-A1- 102014 220 017
- DE-A1- 102018 124 109
- US-A1- 2009 108 850
- US-A1- 2019 001 821
- US-A1- 2019 242 932

## Beschreibung

Die Erfindung bezieht sich unter anderem auf eine Anordnung mit einem Spannungsmodul, das zumindest eine Batterie und/oder zumindest eine Brennstoffzelle umfasst, wobei beide Modulpole des Spannungsmoduls gegenüber einem Modulgehäuse des Spannungsmoduls mittels einer Isolierung isoliert sind.

Im Bereich der Schienenfahrzeug- bzw. Eisenbahntechnik werden zukünftig vermehrt Schienenfahrzeuge mit Spannungsmodulen, die Batterien als Energiespeicher und/oder Brennstoffzellen als Energiequelle enthalten können, ausgestattet.

Der Einsatz von Spannungsmodulen der beschriebenen Art in Schienenfahrzeugen erfordert eine lange Lebensdauer, um Tauschkosten, die unter Umständen bis zu 20 % der Kosten der Schienenfahrzeuge ausmachen können, und kostenintensive Wartungseinsätze, welche insbesondere beim Bahnverkehr äußerst kostspielig sein können, zu vermeiden.

Die Lebensdauer der Spannungsmodule hängt nicht nur von dem Zustand der darin enthaltenen Zellen ab, sondern unter anderem auch von der Isolierung, da die Gefahr elektrischer Schläge oder eines Kurzschlusses oder Brandes zu minimieren ist. Da die Isolierung über die Lebensdauer von 15 bis zu 30 Jahren Vibrationen, Feuchtigkeit und Temperaturschwankungen standhalten soll, werden bei der Fertigung besonders hohe Anforderungen gestellt.

Aus dem Dokument DE 10 2014 220017 A1 ist ein Batteriesystem mit einer Batterie und einer Messeinrichtung zum Messen eines Isolationswiderstands der Batterie bekannt. Aus dem Dokument EP 3 620 800 A1 ist ein Verfahren zur Isolationsüberwachung eines Umrichter-gespeisten Stromversorgungssystems bekannt. Aus dem Dokument DE 10 2018 124 109 A1 ist schließlich eine Isolationsüberwachungseinrichtung bekannt.

Der Erfindung liegt die Aufgabe zugrunde, eine Anordnung mit einem Spannungsmodul anzugeben, die eine Kontrolle der Isolierung des Spannungsmoduls nach der Fertigung sowie auch während des späteren Betriebs, beispielsweise während der Fahrt eines mit der Anordnung ausgestatteten Fahrzeugs, in besonders einfacher Weise erlaubt.

Diese Aufgabe wird erfindungsgemäß durch eine Anordnung mit den Merkmalen gemäß Patentanspruch 1 sowie durch ein Verfahren mit den Merkmalen gemäß Patentanspruch 14 gelöst. Vorteilhafte Ausgestaltungen der erfindungsgemäßen Anordnung und des Verfahrens sind in jeweiligen abhängigen Patentansprüchen angegeben.

Danach ist erfindungsgemäß vorgesehen, dass eine Isolationscharakterisierungseinrichtung vorhanden ist, die zumindest eine Spannungsbereitstellungseinrichtung und eine Messeinrichtung umfasst, wobei die zumindest eine Spannungsbereitstellungseinrichtung geeignet ist, eine zeitlich variable Messspannung, insbesondere eine sinus- oder rechteckförmige Wechselspannung, an die Isolierung anzulegen, und die Messeinrichtung dazu ausgestaltet ist, auftretende Teilentladungsströme, die durch die Isolierung fließen, zu erfassen und auf der Basis der erfassten Teilentladungsströme ein die Isolierung charakterisierendes Messergebnis zu erzeugen.

Ein wesentlicher Vorteil der erfindungsgemäßen Anordnung besteht in der Auswertung von Teilentladungsströmen zur Charakterisierung der Isolierung. Teilentladungsströme können durch Fehlstellen innerhalb der Isolierung bei äußerer Spannungsbeaufschlagung hervorgerufen werden und weisen ein Frequenzspektrum weit oberhalb der üblicherweise im normalen Betrieb der Anordnung auftretenden Arbeitsfrequenzen auf. Auftretende Teilentladungsströme geben somit Hinweise auf Probleme in der Isolierung, wobei sie selbst die Isolierung nicht zerstören.

Bei einer sinusförmigen Wechselspannung von beispielsweise 50 Hz oder 100 Hz als Messspannung entstehen Teilentladungsströme insbesondere in einem Frequenzbereich zwischen einhundert Kilohertz und hundert Megahertz, typischerweise in einem Frequenzbereich zwischen 1 und 5 MHz, wobei die Frequenzen insbesondere abhängig von dem Werkstoff der Isolierung sind. Die Messeinrichtung weist in dem genannten Frequenzbereich eine hohe Messempfindlichkeit auf, um die schwachen Teilentladungsströme detektieren zu können. Diese hohe Messempfindlichkeit wird beispielsweise durch Vorsehen eines Bandpasses oder aufgrund eines grundsätzlichen Hochpassverhaltens sowie einem großen Frequenzabstand zwischen der Messspannung und den Teilentladungsströmen erzielt.

Durch die Überwachung auf das Auftreten relevanter Teilentladungsströme können mit Blick auf eine Charakterisierung der Isolierung meist bessere Messergebnisse erzielt werden als durch einfache Widerstandsmessungen, bei denen der Widerstand der Isolierung unter Bildung eines Widerstandswertes gemessen wird und der Widerstandswert auf das Unterschreiten eines unteren Grenzwertes hin überwacht wird. Dies liegt insbesondere daran, dass Teilentladungsströme nicht nur amplitudenmäßig, sondern auch frequenzmäßig ausgewertet werden können und somit auf das Auftreten neuer Fehlstellen in der Isolierung und/oder auf die weitere Verschlechterung bereits vorhandener Fehlstellen noch früher und deutlicher hindeuten können als reine Widerstandsmesswerte.

Ein weiterer wesentlicher Vorteil der erfindungsgemäßen Anordnung ist darin zu sehen, dass diese eine Überwachung der Isolierung des Spannungsmoduls auch während des späteren Betriebs bzw. Einsatzes des Spannungsmoduls ermöglicht, beispielsweise während der Fahrt im Falle eines Einsatzes der Anordnung innerhalb eines Fahrzeugs.

Vorteilhaft ist es, die mittels der Isolationscharakterisierungseinrichtung vorgenommene Erfassung und Auswertung etwaiger Teilentladungsströme, die bei Entladungsereignissen durch die Isolierung fließen, mit einer einfachen ohmschen Widerstandsmessung, bei der der ohmsche Widerstand der Isolierung auf das Unterschreiten eines unteren Grenzwertes hin überwacht wird, zu kombinieren, um mit besonders großer Sicherheit eine unzulässige Verschlechterung der Isolationseigenschaften der Isolierung rechtzeitig erkennen zu können.

Auch ist es vorteilhaft, wenn das Modulgehäuse mit einem Bezugspotential verbunden ist und an zumindest einen der Modulpole eine Reihenschaltung angeschlossen ist, die eine erste Teilimpedanz, eine zweite Teilimpedanz und einen Mittenanschluss zwischen den Teilimpedanzen umfasst und deren Mittenanschluss mit dem Bezugspotential verbunden ist. Die Teilimpedanzen können ohmsche Anteile, kapazitive Anteile und/oder induktive Anteile enthalten, also beispielsweise ohmsch, ohmsch-kapazitiv oder ohmsch-induktiv sein.

Bei einer Ausführungsform mit zwei Teilimpedanzen ist es besonders vorteilhaft, wenn die zumindest eine Spannungsbereitstellungseinrichtung oder zumindest eine der Spannungsbereitstellungseinrichtungen der Isolationscharakterisierungseinrichtung die erste oder zweite Teilimpedanz umfasst.

Vorteilhaft ist es insbesondere, wenn die zumindest eine Spannungsbereitstellungseinrichtung einen an die Reihenschaltung angeschlossenen Umrichter umfasst, der durch seinen Betrieb und beispielsweise die Wechselwirkung mit den parasitären Kapazitäten der angeschlossenen Betriebsmittel (z. **B.** Motoren, Transformatoren), eine zeitlich variierende Spannung gegenüber dem Bezugspotential erzeugt und als die oder eine der Spannungsbereitstellungseinrichtungen fungiert. Die zeitlich variierende Spannung bildet bzw. erzeugt in diesem Falle zumindest mittelbar die Messspannung für die Isolationscharakterisierungseinrichtung.

Alternativ oder zusätzlich kann vorgesehen sein, dass die zumindest eine Spannungsbereitstellungseinrichtung der Isolationscharakterisierungseinrichtung eine zusätzliche Spannungsquelle umfasst, die elektrisch zwischen einen der Modulpole und das Modulgehäuse und/oder parallel zu der ersten oder der zweiten Teilimpedanz geschaltet ist.

Die Messeinrichtung ist vorzugsweise elektrisch zwischen einen der Modulpole und das Modulgehäuse und/oder elektrisch parallel zu der ersten oder zweiten Teilimpedanz geschaltet.

Die Messeinrichtung und die Spannungsquelle sind vorzugsweise elektrisch parallel geschaltet, wobei beide jeweils zwischen einen der Modulpole und das Modulgehäuse und/oder elektrisch parallel zu der ersten oder zweiten Teilimpedanz geschaltet sind.

Der Umrichter kann das Spannungsmodul in vorteilhafter Weise mit einem Antriebsmotor verbinden.

Der Umrichter umfasst vorzugsweise eine ein- oder mehrphasige Wechselspannungsseite, die mit dem Antriebsmotor in Verbindung steht, und eine Gleichspannungsseite, die mit dem Spannungsmodul in Verbindung steht.

Zwischen das Spannungsmodul und den Umrichter ist vorzugsweise ein DC/DC-Steller geschaltet.

Die Messeinrichtung erzeugt als Messergebnis vorzugsweise ein Warnsignal oder eine Warnangabe, das bzw. die eine unzureichende Isolierung anzeigt, wenn die erfassten Teilentladungsströme über einer vorgegebene Stromschwelle liegen und/oder Entladungen über einer vorgegebenen Entladungsschwelle anzeigen.

Im Rahmen der Erfassung der Teilentladungsströme kann die Messeinrichtung kapazitive Ströme, die beispielsweise beim normalen Betrieb eines Umrichters und/oder DC/DC-Stellers auftreten, aus ihrem Messergebnis zum Beispiel durch Filterung eliminieren, indem sie beispielsweise die beim Betrieb des Umrichters und/oder DC/DC-Stellers auftretenden Arbeitsfrequenzen aus dem von ihr erfassten Strom zum Beispiel durch eine Hochpassfilterung herausfiltert. Der gefilterte Strom bzw. die gefilterten Stromwerte können nachfolgend unter Bildung eines die jeweilige Entladung angebenden Entladungswerts beispielsweise betragsmäßig über vorgegebene Zeitfenster integriert werden; der in dieser Weise gebildete Entladungswert kann dann mit der oben erwähnten Entladungsschwelle verglichen werden. Selbstverständlich können die Teilentladungsströme auch in anderer Weise erfasst und bewertet werden.

Bei einer bevorzugten Ankopplung der Messeinrichtung sind diese und eine Trennkapazität in Reihe geschaltet.

Das Spannungsmodul umfasst vorzugsweise eine Brennstoffzelle, die direkt oder über einen modulinternen DC/DC-Steller parallel zu den Modulpolen geschaltet ist.

Die Erfindung bezieht sich außerdem auf ein Fahrzeug, insbesondere Schienenfahrzeug. Erfindungsgemäß ist vorgesehen, dass das Fahrzeug eine Anordnung wie oben beschrieben aufweist.

Bezüglich der Vorteile des erfindungsgemäßen Fahrzeugs sowie vorteilhafter Ausgestaltungen des erfindungsgemäßen Fahrzeugs sei auf die obigen Ausführungen im Zusammenhang mit der erfindungsgemäßen Anordnung sowie deren vorteilhafter Ausgestaltungen verwiesen.

Die Erfindung bezieht sich außerdem auf ein Verfahren zum Überprüfen einer Isolierung eines Spannungsmoduls, das zumindest eine Batterie und/oder zumindest eine Brennstoffzelle umfasst, wobei beide Modulpole gegenüber einem Modulgehäuse des Spannungsmoduls mittels der Isolierung isoliert sind. Erfindungsgemäß ist vorgesehen, dass mit einer Spannungsbereitstellungseinrichtung eine zeitlich variable Messspannung, insbesondere eine sinus- oder rechteckförmige Wechselspannung, an die Isolierung angelegt wird und auftretende Teilentladungsströme, die durch die Isolierung fließen, erfasst werden und auf der Basis der erfassten Teilentladungsströme ein die Isolierung charakterisierendes Messergebnis erzeugt wird.

Bezüglich der Vorteile des erfindungsgemäßen Verfahrens sowie vorteilhafter Ausgestaltungen des erfindungsgemäßen Verfahrens sei auf die obigen Ausführungen im Zusammenhang mit der erfindungsgemäßen Anordnung sowie deren vorteilhafter Ausgestaltungen verwiesen.

Bei dem Verfahren ist es vorteilhaft, wenn das Verfahren während eines Betriebs, insbesondere während einer Fahrt, eines Fahrzeugs, insbesondere eines Schienenfahrzeugs, zur Prüfung der Isolierung des Spannungsmoduls durchgeführt wird.

Die Erfindung wird nachfolgend anhand von Ausführungsbeispielen näher erläutert; dabei zeigen beispielhaft
- Figur 1: ein Ausführungsbeispiel für eine erfindungsgemäße Anordnung, bei der eine Messspannung für eine Teilentladungsmessung durch den Umrichterbetrieb eines Umrichters der Anordnung hervorgerufen wird,
- Figur 2: ein Ausführungsbeispiel für eine erfindungsgemäße Anordnung, bei der eine zusätzliche Spannungsquelle zur Erzeugung einer Messspannung für eine Teilentladungsmessung vorhanden ist,
- Figur 3: ein Ausführungsbeispiel für eine erfindungsgemäße Anordnung, bei der allein eine Spannungsquelle eine Messspannung für eine Teilentladungsmessung erzeugt,
- Figur 4: ein Ausführungsbeispiel für eine erfindungsgemäße Anordnung, bei der eine Isolationsüberwachungseinrichtung in einem Isolationswiderstandsmessgerät integriert ist,
- Figur 5: in einer schematischen Darstellung das Auftreten von Teilentladungen durch Fehlstellen in einer Isolierung, und
- Figur 6: einen möglichen Verlauf von Teilentladungsströmen durch die in der Figur 5 gezeigten Fehlstellen.

In den Figuren werden der Übersicht halber für identische oder vergleichbare Komponenten stets dieselben Bezugszeichen verwendet.

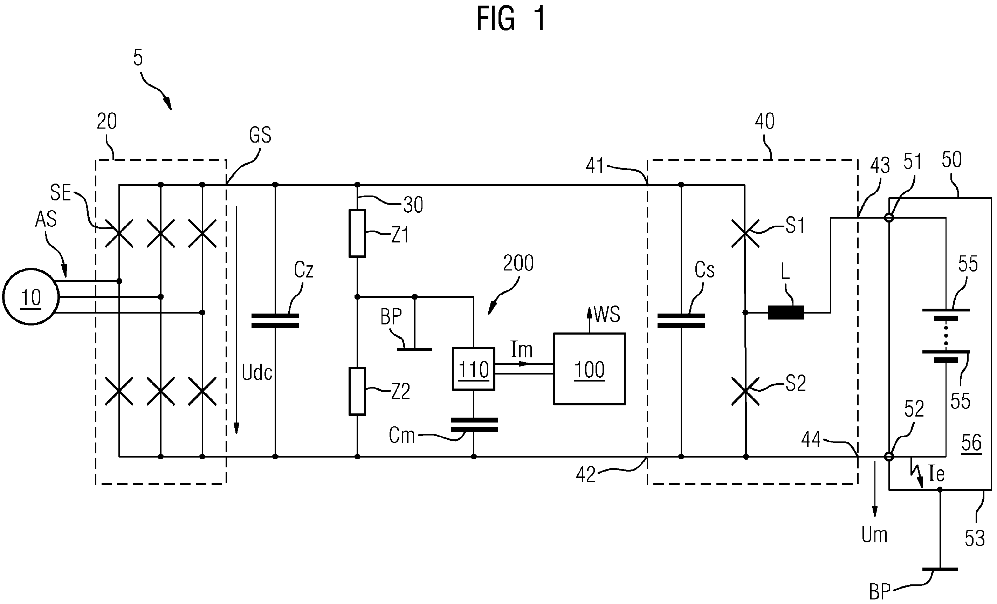

Die Figur 1 zeigt ein erstes Ausführungsbeispiel für eine erfindungsgemäße Anordnung 5**.** Die Anordnung 5 umfasst eine elektrische Komponente 10, bei der es sich beispielsweise um einen Antriebsmotor eines nicht weiter gezeigten Fahrzeugs, insbesondere Schienenfahrzeugs, handeln kann. Die elektrische Komponente 10 ist an eine dreiphasige Wechselspannungsseite AS eines Umrichters 20 angeschlossen, der eine Vielzahl an Schaltelementen SE umfasst. Bei dem Umrichter 20 kann es sich beispielsweise um einen Vierquadrantensteller, einen Multilevel-Umrichter oder dergleichen handeln.

An eine Gleichspannungsseite GS des Umrichters 20 ist eine Zwischenkreiskapazität Cz angeschlossen, an der eine Gleichspannung Udc abfällt.

Parallel zur Zwischenkreiskapazität Cz liegt eine Reihenschaltung 30, die eine erste Teilimpedanz Z1 und eine zweite Teilimpedanz Z2 umfasst. Die Teilimpedanzen Z1 und Z2 können ohmsche Anteile, kapazitive Anteile und/oder induktive Anteile enthalten, also beispielsweise ohmsch, ohmsch-kapazitiv oder ohmsch-induktiv sein. Ein Mittenanschluss zwischen den Teilimpedanzen Z1 und Z2 ist mit einem Bezugspotenzial BP (Masse- oder Erdpotential) der Anordnung 5 verbunden.

Parallel zur Reihenschaltung 30 liegen zwei umrichterseitige Anschlüsse 41 und 42 eines DC/DC-Stellers 40, der bei dem Ausführungsbeispiel gemäß Figur 1 eine stellereigene Kapazität Cs, zwei Schalter S1 und S2 sowie eine Induktivität L umfasst.

An spannungsmodulseitige Anschlüsse 43 und 44 des DC/DC-Stellers 40 sind ein erster Modulpol 51 und ein zweiter Modulpol 52 eines Spannungsmoduls 50 angeschlossen. Das Spannungsmodul 50 umfasst bei dem Ausführungsbeispiel gemäß Figur 1 eine Vielzahl an Batterien 55. Zusätzlich oder alternativ zu den Batterien können auch ein oder mehr Brennstoffzellen vorhanden sein, die jeweils direkt oder über einen spannungsmodulinternen DC/DC-Steller parallel zu den Modulpolen 51 und 52 geschaltet sein können.

Die Modulpole 51 und 52 sind gegenüber einem Gehäuse 53 des Spannungsmoduls 50 mittels einer Isolierung 56, die aus Gründen der Übersicht in der Figur 1 nicht näher gezeigt ist, elektrisch isoliert. Das Gehäuse 53 liegt auf dem Bezugspotential BP.

Die Anordnung 5 gemäß Figur 1 weist darüber hinaus eine Messeinrichtung 100 auf, die bei dem Ausführungsbeispiel gemäß Figur 1 über eine Koppeleinheit 110 in Reihe mit einer Trennkapazität Cm geschaltet ist und somit gemeinsam mit der Trennkapazität Cm parallel zur zweiten Teilimpedanz Z2 der Reihenschaltung 30 liegt.

Durch die elektrische Verschaltung der Messeinrichtung 100 ist diese in der Lage, auftretende Teilentladungsströme Ie, die unter Umständen bei entsprechender Spannungsbeaufschlagung durch die Isolierung 56 des Spannungsmoduls 50 fließen, in einem Messstrom Im zu erkennen und quantitativ zu erfassen und auf der Basis des Messstroms Im bzw. der erfassten Teilentladungsströme Ie ein die Isolierungseigenschaften des Isolationsmaterials der Isolierung 56 charakterisierendes Messergebnis zu erzeugen.

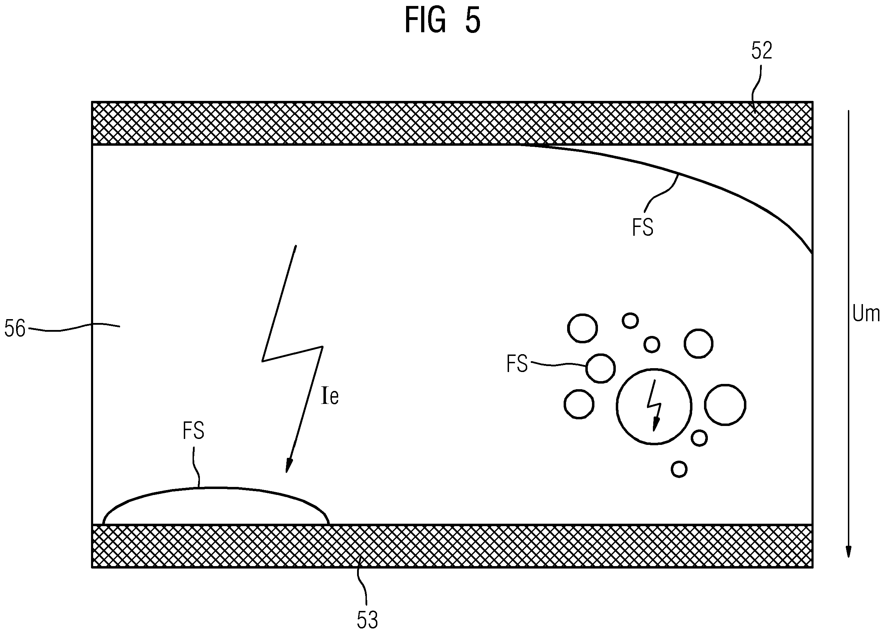

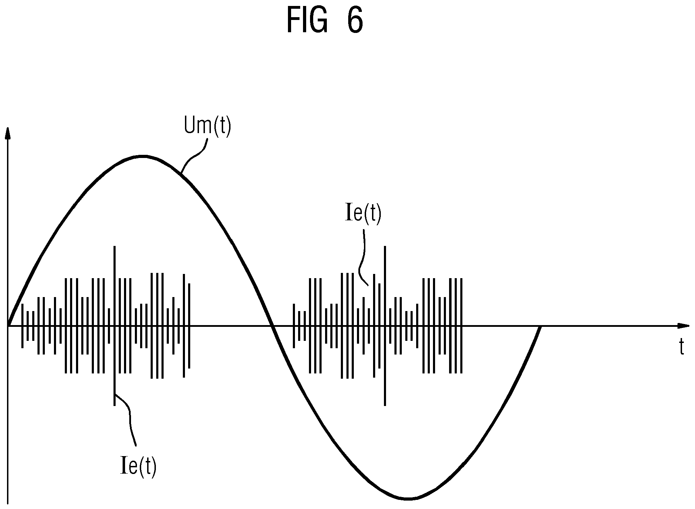

Die Messeinrichtung 100 führt mit anderen Worten einen Teilentladungstest an der Isolierung 56 durch, wie in den Figuren 5 und 6 beispielhaft visualisiert wird:
Liegt beispielsweise eine Messspannung Um von vorzugsweise mindestens 500 V mit ggf. überlagerter DC-Spannung zwischen dem zweiten Modulpol 52 des Spannungsmoduls 50 und dem Betriebspotential BP an, so können an Fehlstellen FS (siehe Figur 5) in der Isolierung 56 Teilentladungen auftreten, die zu Teilentladungsströmen Ie führen. Die Figur 6 zeigt die Teilentladungsströme Ie über der Zeit **t.**

Die Teilentladungsströme Ie können beispielsweise über vorgegebene Messzeitfenster integriert werden. Das jeweilige Integrationsergebnis kann mit einem Grenzschwellenwert, welcher vorzugsweise in einem vorherigen Typtest für das Spannungsmodul 50 bestimmt worden ist, verglichen werden.

Wird der Grenzschwellenwert nicht überschritten, so ist die Isolierung 56 qualitativ in Ordnung und das Spannungsmodul 50 kann weiter eingesetzt werden.

Wird der Grenzschwellenwert hingegen überschritten, so kann die Messeinrichtung 100 als Messergebnis ausgangsseitig ein Warnsignal WS oder eine Warnangabe erzeugen. Das Warnsignal WS wird also erzeugt, wenn die erfassten Teilentladungsströme Ie bzw. die entsprechenden Messströme Im und daraus beispielsweise durch Integration gebildete Ladungswerte eine vorgegebene Entladungsschwelle überschreiten und somit eine unzureichende Isolierung 56 anzeigen.

Um die Teilentladungsströme Ie von kapazitiven Stromanteilen, die über die Isolierung 56 auch ohne Teilentladungseffekte fließen können, zu trennen, können die Messströme Im beispielsweise mittels eines Hochpasses gefiltert werden, damit die Auswertung des Messstroms Im auf die tatsächlich relevanten Teilentladungsströme Ie begrenzt bzw. fokussiert wird.

Die zeitlich variable Messspannung Um wird bei der Anordnung 5 gemäß der Figur 1 durch eine Spannungsbereitstellungseinrichtung erzeugt, die durch die Reihenschaltung 30 sowie den daran angeschlossenen Umrichter 20 gebildet wird, der während seines Betriebs, also betriebsbedingt, eine zeitlich variierende Spannung zwischen dem Bezugspotenzial BP und beispielsweise dem in der Figur 1 zweiten Modulpol 52 hervorruft, die als die Messspannung Um herangezogen werden kann.

Bei der Ausführungsform gemäß Figur 1 lässt sich also in vorteilhafter Weise eine permanente Überwachung der Isolierung 56 des Spannungsmoduls 50 mittels der Messeinrichtung 100 erreichen, indem mit der Messeinrichtung 100 während des Betriebs des Umrichters 50 durchgehend die Teilentladungsströme Ie, sofern diese auftreten bzw. quantitativ erfasst werden, ausgewertet werden.

Bei der Anordnung 5 gemäß Figur 1 bilden somit der Umrichter 20 und die Reihenschaltung 30 eine Spannungsbereitstellungseinrichtung, die wiederum gemeinsam mit der Messeinrichtung 100 eine Isolationscharakterisierungseinrichtung 200 bildet. Die Isolationscharakterisierungseinrichtung 200 gemäß Figur 1 kann - aufgrund der von dem Umrichter 20 während des Umrichterbetriebs durchgehend zur Verfügung gestellten zeitlich variablen Messspannung Um - eine permanente Überwachung der Isolierung 56 durch Erfassen eventuell auftretender Teilentladungsströme Ie durchführen.

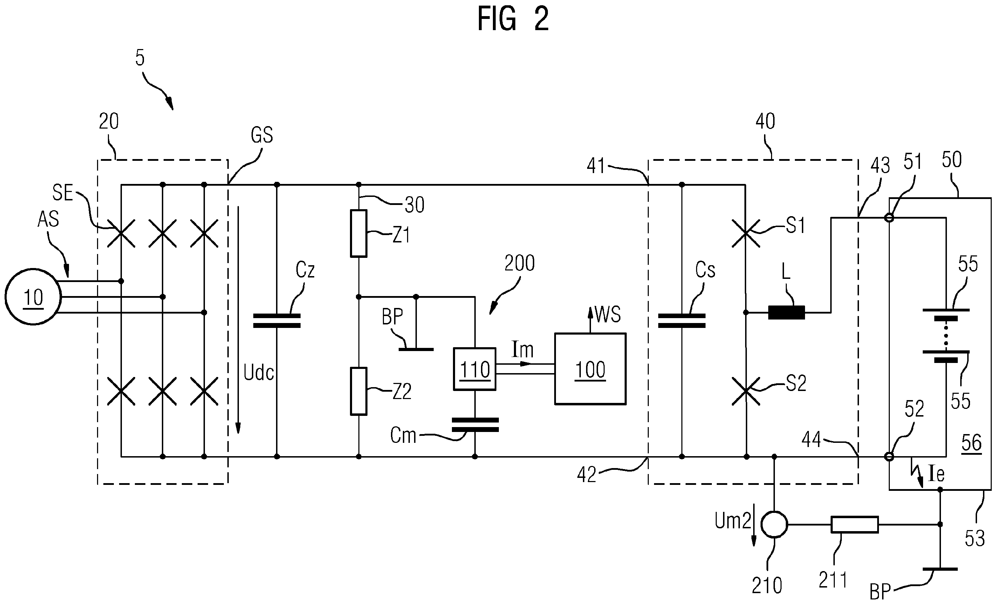

Die Figur 2 zeigt ein zweites Ausführungsbeispiel für eine erfindungsgemäße Anordnung 5, die eine Isolationscharakterisierungseinrichtung 200 zur Erfassung des Isolationszustandes der Isolierung 56 des Spannungsmoduls 50 aufweist.

Im Unterschied zu der Isolationscharakterisierungseinrichtung 200 gemäß Figur 1 weist die Isolationscharakterisierungseinrichtung 200 gemäß Figur 2 eine eigene bzw. zusätzliche Spannungsquelle 210 mit Innenwiderstand 211 auf, die elektrisch zwischen einen der Modulpole, beispielsweise wie in der Figur 2 gezeigt den zweiten Modulpol 52, und das Modulgehäuse 53 geschaltet ist und eine Messspannung Um2 für die Teilentladungsmessung erzeugt. Die Messspannung Um2 ist vorzugsweise sinusförmig und weist vorzugsweise eine Amplitude von mindestens 500 V auf.

Die Messspannung Um2 kann bei entsprechender Höhe und entsprechendem Zeitverlauf ebenfalls zu Teilentladungsströmen Ie führen, die wiederum von der Messeinrichtung 100, die gemeinsam mit der Trennkapazität Cm zwischen dem zweiten Modulpol 52 und dem Bezugspotenzial BP liegt, erfasst werden.

Bei dem Ausführungsbeispiel gemäß der Figur 2 können Teilentladungsmessungen auch ohne aktiven Betrieb des Umrichters 20 durchgeführt werden, weil die nötige Messspannung von der zusätzlichen Spannungsquelle 210 bereitgestellt werden kann.

Im Übrigen gelten die obigen Ausführungen im Zusammenhang mit dem Ausführungsbeispiel gemäß Figur 1 bei dem Ausführungsbeispiel gemäß Figur 2 entsprechend.

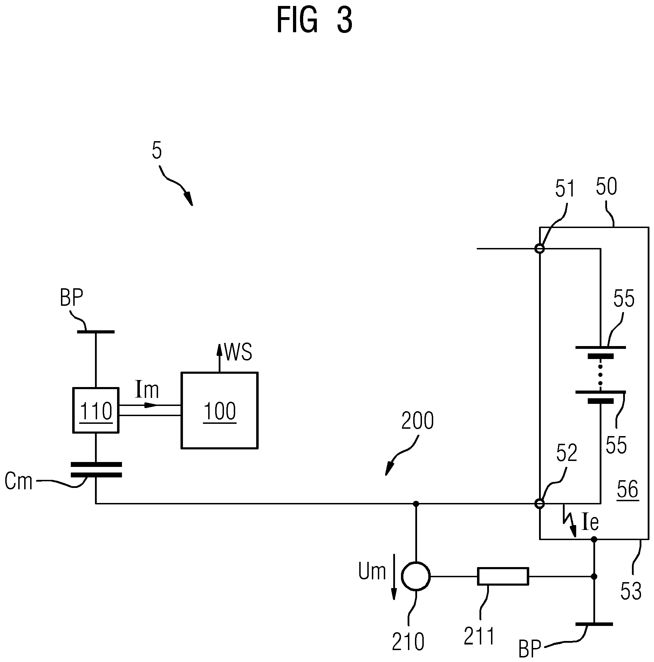

Die Figur 3 zeigt ein drittes Ausführungsbeispiel für eine erfindungsgemäße Anordnung 5. Konkret zeigt die Figur 3 die Isolationsüberwachungseinrichtung 200 des zweiten Ausführungsbeispiels gemäß Figur 2 in einer Anordnung 5, die keinen Umrichter 20 und keinen DC/DC-Steller 40 umfasst. Die Messspannung Um, die Teilentladungsströme Ie bei unzureichender Isolierung 56 zwischen den Modulpolen 51 und 52 des Spannungsmoduls 50 hervorrufen kann, wird allein durch die Spannungsquelle 210 der Isolationscharakterisierungseinrichtung 200 bereitgestellt.

Die Messeinrichtung 100 erfasst gegebenenfalls auftretende Teilentladungsströme Ie und erzeugt gegebenenfalls ein Warnsignal WS, wie dies im Zusammenhang mit den Figuren 1 und 2 oben erläutert wurde; diesbezüglich gelten die obigen Ausführungen für das Ausführungsbeispiel gemäß Figur 3 entsprechend.

Die Isolationscharakterisierungseinrichtung 200 gemäß Figur 3 kann unabhängig von einem Fahrzeug eingesetzt werden, beispielsweise nach einer Herstellung des Spannungsmoduls 50 und noch vor einem Einsatz innerhalb eines Fahrzeugs.

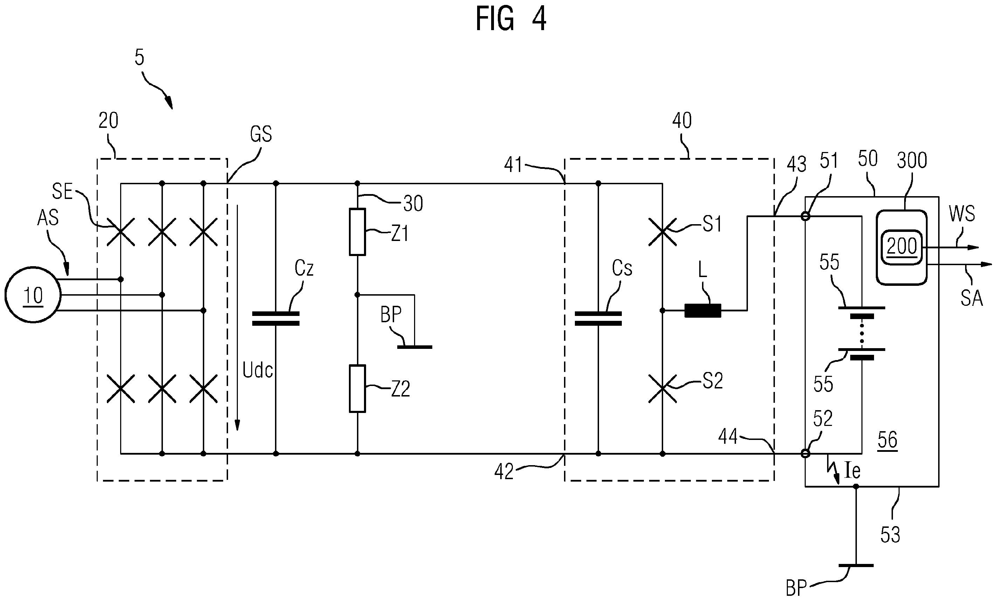

Die Figur 4 zeigt ein viertes Ausführungsbeispiel für eine erfindungsgemäße Anordnung **5.** Die Anordnung 5 gemäß Figur 4 weist ein Isolationswiderstandsmessgerät 300 auf, das den ohmschen Widerstand der Isolierung 56 des Spannungsmoduls 50 misst und ein Alarmsignal SA erzeugt, wenn der ohmsche Widerstand eine untere Widerstandsschwelle unterschreitet. Die elektrische Anbindung des Isolationswiderstandsmessgeräts 300 ist aus Gründen der Übersicht nicht näher dargestellt; das Isolationswiderstandsmessgerät 300 kann beispielsweise zwischen einen beliebigen der beiden Modulpole 51, 52 und das Gehäuse 53 geschaltet sein.

Die Isolationscharakterisierungseinrichtung 200 wie sie oben im Zusammenhang mit den Figuren 1 bis 3 beispielhaft beschrieben worden ist oder zumindest Teile davon wie beispielsweise die Messeinrichtung 100 sind in vorteilhafter Weise in dem Isolationswiderstandsmessgerät 300 integriert, beispielsweise - je nach Ausführungsvariante - als Submodul, insbesondere softwareimplementiertes Submodul, und erzeugt ggf. das oben beschriebene Warnsignal WS, wenn Teilentladungen über ein vorgegebenes Maß hinaus festgestellt werden.

Das Isolationswiderstandsmessgerät 300 mit der darin integrierten Isolationscharakterisierungseinrichtung 200 kann innerhalb des Gehäuses 53 des Spannungsmoduls 50, wie in der Figur 4 gezeigt, oder außerhalb des Gehäuses 53 des Spannungsmoduls 50 angeordnet sein.

Bei den Ausführungsbeispielen gemäß den Figuren 1 und 2 sind die Zwischenkreiskapazität Cz und die Reihenschaltung 30 als separate Komponenten zwischen dem Umrichter 20 und dem DC/DC-Steller 40 dargestellt. Alternativ können die Elemente auch innerhalb des Umrichters 20 und/oder innerhalb des DC/DC-Stellers 40 integriert sein. Beispielsweise kann vorgesehen sein, dass die Zwischenkreiskapazität Cz dem Umrichter 20 zugeordnet ist und die Reihenschaltung 30 im DC/DC-Steller 40 integriert ist.

Die Messeinrichtung 100, die Koppeleinheit 110 und die Trennkapazität Cm der Isolationscharakterisierungseinrichtung 200 sind bei den Ausführungsbeispielen gemäß Figur 1 und 2 als separate Komponenten dargestellt. Alternativ können diese Komponenten auch innerhalb des DC/DC-Stellers 40 oder innerhalb des Spannungsmoduls 50 integriert sein.
- t: Zeit
- Udc: Gleichspannung
- Um: Messspannung
- Um2: Messspannung
- WS: Warnsignal
- Z1: erste Teilimpedanz
- Z2: zweite Teilimpedanz

## Patentansprüche

1. Anordnung (5) mit einem Spannungsmodul (50), das zumindest eine Batterie (55) und/oder zumindest eine Brennstoffzelle umfasst, wobei beide Modulpole (51, 52) des Spannungsmoduls (50) gegenüber einem Modulgehäuse (53) des Spannungsmoduls (50) mittels einer Isolierung (56) isoliert sind, und
mit einer Isolationscharakterisierungseinrichtung (200), die zumindest eine Spannungsbereitstellungseinrichtung und eine Messeinrichtung (100) umfasst,
**dadurch gekennzeichnet, dass**
- die zumindest eine Spannungsbereitstellungseinrichtung geeignet ist, eine zeitlich variable Messspannung (Um), insbesondere eine sinus- oder rechteckförmige Wechselspannung, an die Isolierung (56) anzulegen, und
- die Messeinrichtung (100) dazu ausgestaltet ist, auftretende Teilentladungsströme (Ie), die durch die Isolierung (56) fließen, zu erfassen und auf der Basis der erfassten Teilentladungsströme (Ie) ein die Isolierung (56) charakterisierendes Messergebnis zu erzeugen.

2. Anordnung (5) nach Anspruch 1,
**dadurch gekennzeichnet, dass**
das Modulgehäuse (53) mit einem Bezugspotential (BP) verbunden ist und an zumindest einen der Modulpole (51, 52) eine Reihenschaltung (30) angeschlossen ist, die eine erste Teilimpedanz (Z1), eine zweite Teilimpedanz (Z2) und einen Mittenanschluss zwischen den Teilimpedanzen (Z1, Z2) umfasst und deren Mittenanschluss mit dem Bezugspotential (BP) verbunden ist.

3. Anordnung (5) nach Anspruch 2,
**dadurch gekennzeichnet, dass**
die zumindest eine Spannungsbereitstellungseinrichtung oder zumindest eine der Spannungsbereitstellungseinrichtungen der Isolationscharakterisierungseinrichtung (200) die erste und/oder zweite Teilimpedanz (Z1, Z2) umfasst.

4. Anordnung (5) nach Anspruch 2 oder 3,
**dadurch gekennzeichnet, dass**
die zumindest eine Spannungsbereitstellungseinrichtung einen an die Reihenschaltung (30) angeschlossenen Umrichter (20) umfasst, der durch seinen Betrieb eine zeitlich variierende Spannung gegenüber dem Bezugspotential (BP) erzeugt und als die oder eine der Spannungsbereitstellungseinrichtungen fungiert.

5. Anordnung (5) nach einem der voranstehenden Ansprüche,
**dadurch gekennzeichnet, dass**
die zumindest eine Spannungsbereitstellungseinrichtung eine zusätzliche Spannungsquelle (210) umfasst, die elektrisch zwischen einen der Modulpole (51, 52) und das Modulgehäuse (53) und/oder parallel zu der ersten oder der zweiten Teilimpedanz (Z1, Z2) geschaltet ist.

6. Anordnung (5) nach einem der voranstehenden Ansprüche,
**dadurch gekennzeichnet, dass**
die Messeinrichtung (100) elektrisch zwischen einen der Modulpole (51, 52) und das Modulgehäuse (53) und/oder
elektrisch parallel zu der ersten oder zweiten Teilimpedanz (Z1, Z2) geschaltet ist.

7. Anordnung (5) nach Anspruch 5,
**dadurch gekennzeichnet, dass**
die Messeinrichtung (100) und die Spannungsquelle (210) elektrisch parallel geschaltet sind, wobei beide jeweils zwischen einen der Modulpole (51, 52) und das Modulgehäuse (53) und/oder elektrisch parallel zu der ersten oder zweiten Teilimpedanz (Z1, Z2) geschaltet sind.

8. Anordnung (5) nach einem der Ansprüche 4 bis 7,
**dadurch gekennzeichnet, dass**
- der Umrichter (20) das Spannungsmodul (50) mit einem Antriebsmotor verbindet,
- wobei der Umrichter (20) eine ein- oder mehrphasige Wechselspannungsseite (AS), die mit dem Antriebsmotor in Verbindung steht, und eine Gleichspannungsseite (GS), die mit dem Spannungsmodul (50) in Verbindung steht, umfasst.

9. Anordnung (5) nach einem der Ansprüche 4 bis 8,
**dadurch gekennzeichnet, dass**
zwischen das Spannungsmodul (50) und den Umrichter (20) ein DC/DC-Steller (40) geschaltet ist.

10. Anordnung (5) nach einem der voranstehenden Ansprüche,
**dadurch gekennzeichnet, dass**
die Messeinrichtung (100) als Messergebnis ein Warnsignal (WS) oder eine Warnangabe erzeugt, das bzw. die eine unzureichende Isolierung (56) anzeigt, wenn die erfassten Teilentladungsströme (Ie) über einer vorgegebenen Stromschwelle liegen und/oder Entladungen über einer vorgegebenen Entladungsschwelle anzeigen.

11. Anordnung (5) nach einem der voranstehenden Ansprüche,
**dadurch gekennzeichnet, dass**
die Messeinrichtung (100) und eine Trennkapazität (Cm) in Reihe geschaltet sind.

12. Anordnung (5) nach einem der voranstehenden Ansprüche,
**dadurch gekennzeichnet, dass**
das Spannungsmodul (50) eine Brennstoffzelle umfasst, die direkt oder über einen modulinternen DC/DC-Steller (40) parallel zu den Modulpolen (51, 52) geschaltet ist.

13. Fahrzeug, insbesondere Schienenfahrzeug,
**dadurch gekennzeichnet, dass**
das Fahrzeug eine Anordnung (5) nach einem der voranstehenden Ansprüche umfasst.

14. Verfahren zum Überprüfen einer Isolierung (56) eines Spannungsmoduls (50), das zumindest eine Batterie (55) und/oder zumindest eine Brennstoffzelle umfasst, wobei beide Modulpole (51, 52) gegenüber einem Modulgehäuse (53) des Spannungsmoduls (50) mittels der Isolierung (56) isoliert sind,
**dadurch gekennzeichnet, dass**
- mit einer Spannungsbereitstellungseinrichtung eine zeitlich variable Messspannung (Um), insbesondere eine sinus- oder rechteckförmige Wechselspannung, an die Isolierung (56) angelegt wird und
- auftretende Teilentladungsströme (Ie), die durch die Isolierung (56) fließen, erfasst werden und auf der Basis der erfassten Teilentladungsströme (Ie) ein die Isolierung (56) charakterisierendes Messergebnis erzeugt wird.

15. Verfahren nach Anspruch 14,
**dadurch gekennzeichnet, dass**
das Verfahren während eines Betriebs eines Fahrzeugs, insbesondere eines Schienenfahrzeugs, zur Prüfung der Isolierung (56) des Spannungsmoduls (50) durchgeführt wird.

## Claims

1. Arrangement (5) with a voltage module (50), which comprises at least one battery (55) and/or at least one fuel cell,
wherein both module poles (51, 52) of the voltage module (50) are insulated with respect to a module housing (53) of the voltage module (50) by means of an insulation (56), and with an insulation characterisation facility (200), which comprises at least one voltage provisioning facility and a measuring facility (100),
**characterised in that**
- the at least one voltage provisioning facility is suited to applying a temporally variable measuring voltage (Um), in particular a sinusoidal or rectangular alternating voltage, to the insulation (56), and
- the measuring facility (100) is designed to capture developing partial discharge currents (Ie) which flow through the insulation (56) and on the basis of the captured partial discharge currents (Ie) to generate a measuring result which characterises the insulation (56).

2. Arrangement (5) according to claim **1,**
**characterised in that**
the module housing (53) is connected to a reference potential (BP) and a series circuit (30) is connected to at least one of the module poles (51, 52), said series circuit comprising a first partial impedance (Z1), a second partial impedance (Z2) and a centre connection between the partial impedances (Z1, Z2) and the centre connection of which is connected to the reference potential (BP).

3. Arrangement (5) according to claim **2,**
**characterised in that**
the at least one voltage provisioning facility or at least one of the voltage provisioning facilities of the insulation characterisation facility (200) comprises the first and/or second partial impedance (Z1, Z2).

4. Arrangement (5) according to claim 2 or **3,**
**characterised in that**
the at least one voltage provisioning facility comprises a converter (20) connected to the series circuit (30), which, on account of its operation, generates a temporally varying voltage with respect to the reference potential (BP) and functions as the or one of the voltage provisioning facilities.

5. Arrangement (5) according to one of the preceding claims, **characterised in that** the at least one voltage provisioning facility comprises an additional voltage source (210), which is connected electrically between one of the module poles (51, 52) and the module housing (53) and/or in parallel with the first or the second partial impedance (Z1, Z2).

6. Arrangement (5) according to one of the preceding claims, **characterised in that**
the measuring facility (100) is connected electrically between one of the module poles (51, 52) and the module housing (53) and/or electrically in parallel with the first or second partial impedance (Z1, Z2).

7. Arrangement (5) according to claim **5,**
**characterised in that**
the measuring facility (100) and the voltage source (210) are connected electrically in parallel, wherein both are connected in each case between one of the module poles (51, 52) and the module housing (53) and/or electrically in parallel with the first or second partial impedance (Z1, Z2).

8. Arrangement (5) according to one of claims 4 to **7,**
**characterised in that**
- the converter (20) connects the voltage module (50) to a drive motor,
- wherein the converter (20) comprises a single-phase or multiphase alternating voltage side (AS), which is connected to the drive motor, and a direct voltage side (GS), which is connected to the voltage module (50).

9. Arrangement (5) according to one of claims 4 to **8,**
**characterised in that**
a DC/DC actuator (40) is connected between the voltage module (50) and the converter (20).

10. Arrangement (5) according to one of the preceding claims,
**characterised in that**
the measuring facility (100) generates a warning signal (WS) or a warning message as a measuring result, which indicates an inadequate insulation (56), if the captured partial discharge currents (Ie) lie above a predetermined current threshold and/or indicate discharges above a predetermined discharge threshold.

11. Arrangement (5) according to one of the preceding claims, **characterised in that**
the measuring facility (100) and a separation capacitance (Cm) are connected in series.

12. Arrangement (5) according to one of the preceding claims, **characterised in that**
the voltage module (50) comprises a fuel cell, which is connected in parallel with the module poles (51, 52) directly or by way of a module-internal DC/DC actuator (40).

13. Vehicle, in particular rail vehicle,
**characterised in that**
the vehicle comprises an arrangement (5) according to one of the preceding claims.

14. Method for checking an insulation (56) of a voltage module (50), which comprises at least one battery (55) and/or at least one fuel cell, wherein both module poles (51, 52) are insulated with respect to a module housing (53) of the voltage module (50) by means of the insulation (56),
**characterised in that**
- with a voltage provisioning facility, a temporally variable measuring voltage (Um), in particular a sinusoidal or rectangular alternating voltage, is applied to the insulation (56), and
- developing partial discharge currents (Ie), which flow through the insulation (56), are captured and a measuring result characterising the insulation (56) is generated on the basis of the captured partial discharge currents (Ie).

15. Method according to claim 14,
**characterised in that**
the method is carried out during an operation of a vehicle, in particular a rail vehicle, in order to check the insulation (56) of the voltage module (50).

## Revendications

1. Agencement (5) comprenant un module (50) de tension, qui comprend au moins une batterie (55) et/ou au moins une pile à combustible, dans lequel les deux pôles (51, 52) du module (50) de tension sont, au moyen d'une isolation (56), isolés par rapport à un boîtier (53) du module (50) de tension, et comprenant un dispositif (200) de caractérisation de l'isolation, qui comprend au moins un dispositif de mise à disposition d'une tension et un dispositif (100) de mesure,
**caractérisé en ce que**
- le au moins un dispositif de mise à disposition d'une tension est propre à appliquer à l'isolation (56) une tension (Um) de mesure variable dans le temps, en particulier une tension alternative de forme sinusoïdale ou rectangulaire, et
- le dispositif (100) de mesure est conformé pour détecter des courants (Ie) de décharge partielle, qui se produisent et qui passent dans l'isolation (56), et pour produire, sur la base des courants (Ie) de décharge partielle détectés, un résultat de mesure caractérisant l'isolation (56).

2. Agencement (5) suivant la revendication **1,**
**caractérisé en ce que**
le boîtier (53) du module est relié à un potentiel (BP) de référence et, à au moins l'un des pôles (51, 52) du module, est connecté un circuit (30) série, qui comprend une première impédance (Z1) partielle, une deuxième impédance (Z2) partielle et une borne médiane entre les impédances (Z1, Z2) partielles et dont la borne médiane est reliée au potentiel (BP) de référence.

3. Agencement (5) suivant la revendication **2,**
**caractérisé en ce que**
le au moins un dispositif de mise à disposition d'une tension ou au moins l'un des dispositifs de mise à disposition d'une tension du dispositif (200) de caractérisation de l'isolation comprend la première et/ou la deuxième impédance (Z1, Z2) partielle.

4. Agencement (5) suivant la revendication 2 ou **3,**
**caractérisé en ce que**
le au moins un dispositif de mise à disposition d'une tension comprend un onduleur (20), qui est connecté au circuit (30) série et qui, par son fonctionnement, produit une tension variant en fonction du temps par rapport au potentiel (BP) de référence et sert du ou de l'un des dispositifs de mise à disposition d'une tension.

5. Agencement (5) suivant l'une des revendications précédentes,
**caractérisé en ce que**
le au moins un dispositif de mise à disposition d'une tension comprend une source (210) supplémentaire de tension, qui est montée électriquement entre l'un des pôles (51, 52) du module et le boîtier (53) du module et/ou en parallèle avec la première ou la deuxième impédance (Z1, Z2) partielle.

6. Agencement (5) suivant l'une des revendications précédentes,
**caractérisé en ce que**
le dispositif (100) de mesure est monté électriquement entre l'un des pôles (51, 52) du module et le boîtier (53) du module et/ou électriquement en parallèle avec la première ou la deuxième impédance (Z1, Z2) partielle.

7. Agencement (5) suivant la revendication 5,
**caractérisé en ce que**
le dispositif (100) de mesure et la source (210) de tension sont montés électriquement en parallèle, dans lequel les deux sont montés respectivement entre l'un des pôles (51, 52) du module et le boîtier (53) du module et/ou électriquement en parallèle avec la première ou la deuxième impédance (Z1, Z2) partielle.

8. Agencement (5) suivant l'une des revendications 4 à 7,
**caractérisé en ce que**
- l'onduleur (20) connecte le module (50) de tension à un moteur d'entraînement,
- dans lequel l'onduleur (20) comprend un côté (AS) monophasé ou polyphasé de tension alternative, qui est en liaison avec le moteur d'entraînement, et un côté (GS) de tension continue, qui est en liaison avec le module (50) de tension.

9. Agencement (5) suivant l'une des revendications 4 à 8,
**caractérisé en ce qu'**
un régleur (40) courant continu/courant continu est monté entre le module (50) de tension et l'onduleur (20).

10. Agencement (5) suivant l'une des revendications précédentes,
**caractérisé en ce que**
le dispositif (100) de mesure produit comme résultat de mesure un signal (WS) d'alerte ou une indication d'alerte, qui indique une isolation (56) insuffisante, si les courants (Ie) de décharge partielle détectés sont au-dessus d'un seuil de courant donné à l'avance et/ou si des décharges sont au-dessus d'un seuil de décharge donné à l'avance.

11. Agencement (5) suivant l'une des revendications précédentes,
**caractérisé en ce que**
le dispositif (100) de mesure et une capacité (Cm) de sectionnement sont montés en série.

12. Agencement (5) suivant l'une des revendications précédentes,
**caractérisé en ce que**
le module (50) de tension comprend une pile à combustible, qui est montée, directement ou par un régleur (40) courant continu/courant continu interne au moteur, en parallèle avec les pôles (51, 52) du module.

13. Véhicule, en particulier véhicule ferroviaire,
**caractérisé en ce que**
le véhicule comprend un agencement (5) suivant l'une des revendications précédentes.

14. Procédé de contrôle d'une isolation (56) d'un module (50) de tension, qui comprend au moins une batterie (55) et/ou au moins une pile à combustible, dans lequel les deux pôles (51, 52) du module sont, au moyen de l'isolation (56), isolés par rapport à un boîtier (53) du module (50) de tension,
**caractérisé en ce que**
- par un dispositif de mise à disposition d'une tension, on applique à l'isolation (56) une tension (Um) de mesure variable en fonction du temps, en particulier une tension alternative sinusoïdale ou rectangulaire, et
- on détecte des courants (Ie) de décharge partielle, qui se produisent et qui passent dans l'isolation (56) et, sur la base des courants (Ie) de décharge partielle détectés, on produit un résultat de mesure caractérisant l'isolation (56).

15. Procédé suivant la revendication 14,
**caractérisé en ce que** l'
on effectue le procédé pendant un fonctionnement du véhicule, en particulier d'un véhicule ferroviaire, pour le contrôle de l'isolation (56) du module (50) de tension.
